# EUROPEAN PATENT APPLICATION

(11) **EP 2 400 535 A1**
(43) Date of publication of application: **28.12.2011**
(21) Application number: 09840402.3
(22) Date of filing: 15.09.2009
(51) Int. Cl.: H01L 21/683, C23C 16/458, H01L 21/205, H01L 21/3065, H05H 1/46

(54) **SUBSTRATE SUPPORT TABLE OF PLASMA PROCESSING DEVICE**

(30) Priority: 23.02.2009 JP 2009038820
(71) Applicant: Mitsubishi Heavy Industries, Ltd., Tokyo 108-8215 (JP)
(72) Inventor: KAFUKU Hidetaka, Takasago-shi Hyogo 676-8686 (JP); MATSUKURA Akihiko, Kobe-shi Hyogo 652-8585 (JP); YANAGIDA Hisashi, Kobe-shi Hyogo 652-8585 (JP)
(74) Representative: HOFFMANN EITLE
(86) International application number: PCT/JP2009/066065
(87) International publication number: WO 2010/095299

(57) **Abstract**

Provided is a substrate support table of a plasma processing device, which stably controls a substrate at a relatively high temperature. The substrate support table comprises an electrostatic attraction plate (14) containing a first electrode for holding a substrate (W) by electrostatic attraction, a second electrode for applying a bias to the substrate (W), and a heater for heating the substrate, a cylindrical flange (13) welded to the lower surface of the electrostatic attraction plate (14) and produced from an alloy having the same heat characteristic as the electrostatic attraction plate (14), and a support table (10) comprising an O-ring (12) in a surface facing the lower surface of the flange (13), to which the flange (13) is attached via the O-ring (12), wherein when the bias power to be applied to the substrate (W) is changed, the heater power for heating the substrate (W); is changed so that the temperature of the substrate (W) is constant.

## Description

### TECHNICAL FIELD

The present invention relates to a substrate support stage (table) for supporting a substrate in a plasma processing apparatus (device).

### BACKGROUND ART

In a plasma processing apparatus, such as a plasma CVD (Chemical Vapor Deposition) apparatus or a plasma etching apparatus, a substrate made of a semiconductor such as Si (silicon) is supported on a substrate support stage. The substrate support stage is provided with an electrostatic chuck which is made of a ceramic (for example, aluminum nitride (AIN) or the like) and which electrostatically attracts and holds the substrate. The electrostatic chuck is provided with a bias electrode for applying a bias to the substrate in addition to an electrostatic chuck electrode. Thus, the electrostatic chuck has not only a function to attract and hold the substrate, but also a function to apply a bias.
Patent Document 1: Japanese Examined Patent Application Publication No. Hei 7-51754
Patent Document 2: Japanese Patent Application Publication No. 2007-217733

### DISCLOSURE OF THE INVENTION

### PROBLEMS TO BE SOLVED BY THE INVENTION

In a semiconductor device, an insulating film for a semiconductor device is formed by using, for example, a plasma CVD apparatus. The insulating film for a semiconductor device is required to have a high water resistance and a high heat resistance for the purpose of securing the reliability of the semiconductor device. To improve the water resistance and the heat resistance of such an insulating film for a semiconductor device, it is effective to elevate the substrate temperature during formation of the film.

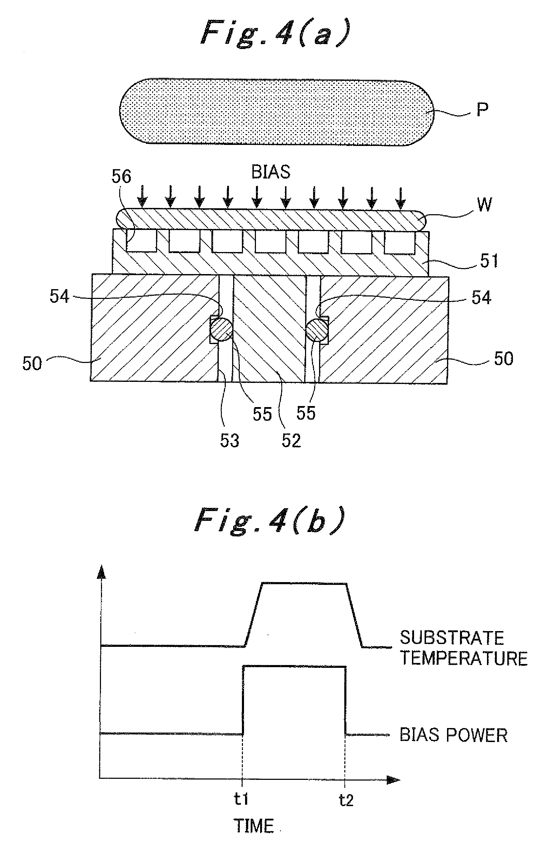

Conventionally, to elevate the substrate temperature, a substrate support stage is used in which a large number of dimples 56 are provided on a surface of an electrostatic chuck 51 attached to a support stage 50 as shown in Part (a) of Fig. 4. By providing a large number of the dimples 56 on the surface of the electrostatic chuck 51 in this way, heat transfer from a substrate W to the electrostatic chuck 51 is reduced, so that the substrate temperature is elevated. Note that reference numeral 52 in the figure denotes a connection terminal connected to a bias/electrostatic chuck common electrode (not illustrated) provided inside the electrostatic chuck 51, and the connection terminal 52 is sealed with an O-ring groove 54 and an O-ring 55 provided in an opening portion 53 penetrating a center portion of the support stage 50, so that the vacuum in a vacuum chamber is maintained.

However, the substrate support stage having the above-described structure has such a problem that the temperature of the substrate W is greatly influenced by heat coming from the outside, and, for example, when the bias power applied to the substrate W is changed, the temperature of the substrate W also changes. Specifically, suppose a case where a plasma P is generated in the vacuum chamber, and a bias is applied to the substrate W having electrostatically attracted. In such a case, as shown in the time chart in Part (b) of Fig. 4, the temperature of the substrate W is affected by the bias power applied around time t1 and t2 during film formation in the following manner. Specifically, when the bias power is increased, the temperature of the substrate W rises, whereas when the bias power is reduced, the temperature of the substrate W lowers, As a result, it is difficult to control stably the substrate W at a desired constant temperature.

The present invention has been made in view of the above-described problems, and an object of the present invention is to provide a substrate support stage of a plasma processing apparatus in which a substrate is stably controlled at relatively high temperature.

### MEANS FOR SOLVING THE PROBLEMS

A substrate support stage of a plasma processing apparatus according to a first invention which solves the aforementioned problems is a substrate support stage of a plasma processing apparatus, comprising: an electrostatic attraction plate incorporating a first electrode for electrostatically attracting a substrate, a second electrode for applying a bias to the substrate, and a heater for heating the substrate; a tubular flange which is welded to a lower surface of the electrostatic attraction plate and which is made of an alloy having thermal characteristics similar to thermal characteristics of the electrostatic attraction plate; and a support stage which has a sealing member on a surface facing a lower surface of the flange, and to which the flange is attached with the sealing member being interposed therebetween, wherein when a bias power supplied to the second electrode is changed, a heater power supplied to the heater is changed to thereby keep the temperature of the substrate constant.
For example, when the bias power is increased, the heater power is decreased, and when the bias power is decreased, the heater power is increased to thereby keep the temperature of the substrate constant.

A substrate support stage of a plasma processing apparatus according to a second invention which solves the aforementioned problems is the substrate support stage of a plasma processing apparatus according to the first invention, wherein the flange has such a height to form a temperature gradient in which the temperature of the lower surface of the flange is 200°C or below.

A substrate support stage of a plasma processing apparatus according to a third invention which solves the aforementioned problems is the substrate support stage of a plasma processing apparatus according to the first or second invention, wherein an outer peripheral surface of the flange is coated with a coating material having a high plasma resistance against a plasma of a fluorine-based gas.

A substrate support stage of a plasma processing apparatus according to a fourth invention which solves the aforementioned problems is the substrate support stage of a plasma processing apparatus according to any one of the first to third inventions, wherein a ring-shaped member is provided on an upper surface of the support stage on an outer periphery side of the flange in such a manner that a gap between the ring-shaped member and each of an outer peripheral surface of the flange and the lower surface of the electrostatic attraction plate is 0.5 mm or more, and 2.0 mm or less.

A substrate support stage of a plasma processing apparatus according to a fifth invention which solves the aforementioned problems is the substrate support stage of a plasma processing apparatus according to any one of the first to fourth inventions, wherein a first connection terminal to be connected to the first electrode, a second connection terminal to be connected to the second electrode, and a third connection terminal to be connected to the heater are disposed on an inner periphery side of the flange, and are connected to the first electrode, the second electrode, and the heater, respectively, whereby the first connection terminal, the second connection terminal, and the third connection terminal are disposed on an atmosphere side, which is the inner periphery side of the flange.

A substrate support stage of a plasma processing apparatus according to a sixth invention which solves the aforementioned problems is the substrate support stage of a plasma processing apparatus according to any one of the first to fifth inventions, wherein a flow path is provided in the support stage, and a coolant for cooling the support stage is allowed to flow through the flow path.

### EFFECTS OF THE INVENTION

According to the first and second inventions, the tubular flange is welded to the lower surface of the electrostatic attraction plate; the electrostatic attraction plate is attached to the support stage with the flange interposed therebetween; and when the bias power is changed, the heater power is changed to thereby keep the temperature of the substrate constant. Consequently, the substrate can be stably controlled at relatively high temperature (for example, 300°C to 400°C). As a result, a thin film having a high film quality can be formed in a case of a plasma CVD apparatus, for example. In addition, since the temperature around the sealing member located on the lower surface of the flange is low even when the substrate is at a relatively high temperature, an O-ring can be used as the sealing member, so that the maintainability thereof is improved.

According to the third invention, since the flange outer peripheral surface is coated with a material having a high plasma resistance, the corrosion of the flange itself can be inhibited.

According to the fourth invention, the ring-shaped member is provided on the upper surface of the support stage on the flange outer periphery side, with the gap between the flange outer peripheral surface and the lower surface of the electrostatic attraction plate being 0.5 mm or more, and 2.0 mm or less. Hence, the electrical discharge can be prevented on the lower surface of the electrostatic attraction plate.

According to the fifth invention, the first electrode, the second electrode, and the heater are connected in a portion on the flange inner periphery side, i.e., the atmosphere side respectively to the first connection terminal, the second connection terminal, and the third connection terminal. Hence, the electrical discharge by the first connection terminal, the second connection terminal, and the third connection terminal can be prevented.

According to the sixth invention, the flow path is provided in the support stage, and a coolant for cooling the support stage is allowed to flow therethrough. Hence, the temperature of the sealing member is further lowered, so that the lifetime of the sealing member can be extended.

### BRIEF DESCRIPTION OF THE DRAWINGS

[Fig. 1] Part (a) of Fig. 1 is a longitudinal cross-sectional view showing an example of an embodiment of a substrate support stage of a plasma processing apparatus according to the present invention, and Part (b) of Fig. 1 is a time chart for illustrating an example of control conducted in the substrate support stage.
[Fig. 2] Fig. 2 is a longitudinal cross-sectional view showing another example of an embodiment of a substrate support stage of a plasma processing apparatus according to the present invention.
[Fig. 3] Fig. 3 is a longitudinal cross-sectional view showing yet another example of an embodiment of a substrate support stage of a plasma processing apparatus according to the present invention.
[Fig. 4] Part (a) of Fig. 4 is a longitudinal cross-sectional view of a conventional substrate support stage of a plasma processing apparatus, and Part (b) of Fig. 4 is a time chart for illustrating problems in the substrate support stage.

### EXPLANATION OF REFERENCE NUMERALS

- 10: support stage
- 11: O-ring groove
- 12: O-ring
- 13: flange,
- 14: electrostatic chuck
- 17: opening portion
- 18: chuck temperature detection sensor terminal
- 19: common connection terminal
- 20: heater connection terminal
- 21: substrate temperature detection sensor terminal

### BEST MODES FOR CARRYING OUT THE INVENTION

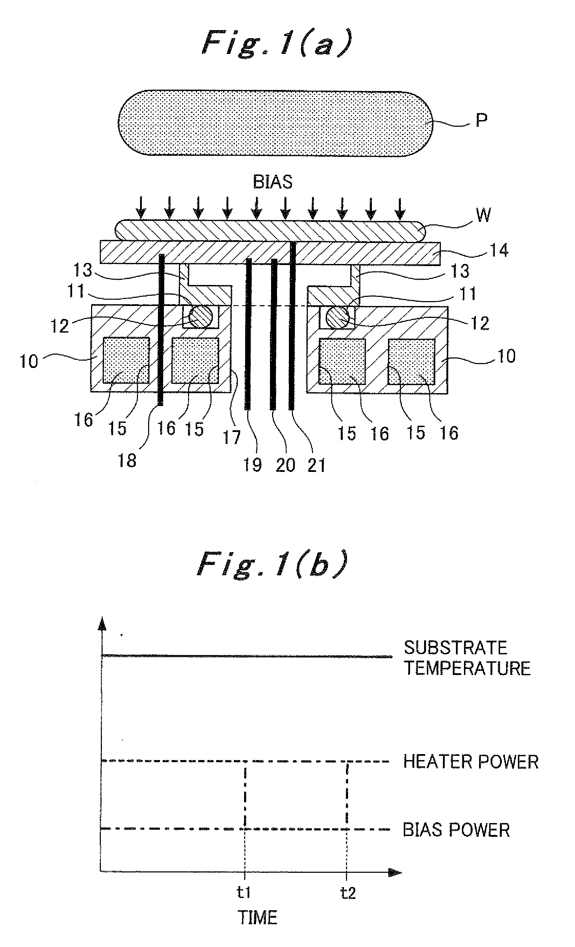

Description will be given of an embodiment of a substrate support stage of a plasma processing apparatus according to the present invention with reference to Figs. 1 to 3.

### (Embodiment 1)

Part (a) of Fig. 1 is a longitudinal cross-sectional view an example of an embodiment of a substrate support stage of a plasma processing apparatus according to the present invention, and Part (b) of Fig. 1 is a time chart for illustrating an example of control conducted in the substrate support stage. Note that the substrate support stage of this embodiment is to be disposed in a vacuum chamber of a plasma processing apparatus (for example, a plasma CVD apparatus, a plasma etching apparatus, or the like), but herein the structures other than that of the substrate support stage, such as the structures of the vacuum chamber, a plasma generation mechanism, and the like are not shown.

The substrate support stage of this embodiment has a support stage 10 which is disposed inside a vacuum chamber and made of metal (for example, aluminum or the like), and an electrostatic chuck 14 (electrostatic attraction plate) attached to an upper surface of the support stage 10. A cylindrical flange 13 is provided under the electrostatic chuck 14. A lower portion of the flange 13 is shaped to provide an L-shaped cross-section. The lower surface of the flange 13 is disposed on an upper surface of the support stage 10. In addition, an O-ring groove 11 is provided at a position, on the upper surface of the support stage 10, facing the lower surface of the flange 13, and an O-ring 12 (sealing member) is disposed in the O-ring groove 11. In other words, the O-ring groove 11, the O-ring 12, and the flange 13 are laid between the support stage 10 and the electrostatic chuck 14. The electrostatic chuck 14 is attached to the upper surface of the support stage 10, with the O-ring groove 11, the O-ring 12, and the flange 13 being interposed therebetween.

The electrostatic chuck 14 is made of a ceramic (for example, aluminum nitride (AIN), or the like) which electrostatically attracts and holds a substrate W made of a semiconductor such as Si (silicon). The electrostatic chuck 14 incorporates an electrostatic chuck electrode (a first electrode; not illustrated), and also incorporates a bias electrode (a second electrode; not illustrated) for applying a bias to the substrate, a heater (not illustrated) for controlling the temperature of the substrate, and the like. In other words, the electrostatic chuck 14 has not only a function to attract and hold the substrate, but also functions to apply a bias and to control temperature. Note that a single electrode can be commonly used as the electrostatic chuck electrode and the bias electrode, and a single electrode is commonly used in this embodiment.

In addition, to improve the heat transfer with the substrate W, the entire surface of the electrostatic chuck 14 is made flat, and has a surface roughness of Ra 0.8 or less.

The flange 13 is welded to the lower surface of the electrostatic chuck 14 by brazing or the like, so that the electrostatic chuck 14 is integrated with the flange 13. In other words, there is no gap between the flange 13 and the electrostatic chuck 14, and the seal in the substrate support stage is achieved by the O-ring 12 between the lower surface of the flange 13 and the upper surface of the support stage 10. An outer periphery side of the O-ring 12 is hermetically sealed as a vacuum chamber side, whereas the inner periphery side of the O-ring 12 is on the atmosphere side. Note that, although not illustrated, bolts in the vicinity of the O-ring 12 are used to attach the lower portion of the flange 13 to the support stage 10 to thereby fix the electrostatic chuck 14 and the flange 13.

In consideration of thermal stress, Kovar (Registered Trademark), which is a Co-Fe-Ni-based alloy having thermal characteristics close to those of the ceramic electrostatic chuck 14, is used for the flange 13. Note that any other alloy such as Alloy 42 or NSL may be used, as long as the alloy has thermal characteristics close to those of the ceramic electrostatic chuck 14.

In addition, except the lower portion which is to be fixed to the support stage 10, the flange 13 is formed in a small thickness (for example, 0.5 mm in thickness). In addition, the flange 13 is formed so that a predetermined distance can be provided between the electrostatic chuck 14 and the support stage 10. With the small thickness of the flange 13, the flange 13 itself serves as a heat transfer resistor. In addition, by providing the distance between the electrostatic chuck 14 and the support stage 10, a temperature gradient is formed in the flange 13 itself, and a sealing surface (the contact surface with the O-ring 12) is set at a position away from the substrate W and from the electrostatic chuck 14.

In addition, the inner diameter of the flange 13 is preferably made as small as possible because of the following reason. Specifically, the inner periphery side of the flange 13 is on the atmosphere side. Accordingly, when the inside of the vacuum chamber is evacuated, a force originated from the atmospheric pressure acts on a portion over which the surface of the electrostatic chuck 13 is exposed to the atmospheric pressure. In this case, a larger inner diameter results in a larger force applied to this portion. For this reason, by reducing the inner diameter of the flange 13, the area of the portion over which the electrostatic chuck 13 is exposed to the atmospheric pressure is reduced, so that the force of the atmospheric pressure pushing the electrostatic chuck 13 upward is reduced.

Almost all heat transfer from the substrate W side and from the electrostatic chuck 14 side occurs through the flange 13. By employing the above-described structure of the flange 13, the heat transfer from the substrate W side and the electrostatic chuck 14 side to the support stage 10 side is suppressed, and a temperature gradient is formed. In addition, by providing the sealing surface on the lower surface of the flange 13 as described above, the sealing surface can be at or below a heat resistant temperature of the O-ring 12 even when the substrate W side and the electrostatic chuck 14 side are at high-temperature. As a result, the substrate W can be set at a desired high-temperature. In addition, it is no more necessary to use a sealing member such as a metal seal, and a fluorine resin-based O-ring having good maintainability can be used as the sealing member.

Accordingly, the height of the flange 13 is determined so that a temperature gradient is formed in which the temperature of the lower surface of the flange 13 is at or below the heat resistant temperature of the O-ring 12. For example, in a case where the temperature of the substrate W is controlled at 400°C, by setting the height of the flange 13 at 25 mm or more, the temperature on the lower surface of the flange 13 can be at or below 200°C, which is the heat resistant temperature of the O-ring 12. In this way, the height of the flange 13 is determined depending on the control temperature of the substrate W.

In addition, an opening portion 17 penetrating the support stage 10 is provided in a center portion of the support stage 10. The opening portion 17 is on the inner periphery side of the O-ring 12, and communicates with a hollow portion of the flange 13. Moreover, a common connection terminal 19 (a first and second connection terminal) for connection to the bias/electrostatic chuck common electrode and a heater connection terminal 20 (a third connection terminal) for connection to the heater are led out from the lower surface of the electrostatic chuck 14, through the hollow portion of the flange 13 and the opening portion 17. In other words, the common connection terminal 19 and the heater connection terminal 20 are disposed to be on the atmosphere side, which is the inner periphery side of the O-ring 12, in other words, not to be on the vacuum side. As a result, even when a high electric power and a high voltage are applied to the common connection terminal 19 or the heater connection terminal 20, electrical discharge can be prevented from occurring because the common connection terminal 19 and the heater connection terminal 20 are surrounded with the air.

For example, suppose a case where a DC voltage is supplied to the common connection terminal 19 to thereby electrostatically attract the substrate W to the electrostatic chuck 14, and a high-frequency electric power is supplied also to the connection terminal 19 to thereby apply a bias to the substrate W. In this case, since the common connection terminal 19 is surrounded with the air, the electrical discharge can be prevented from occurring even when a high electric power and a high voltage are applied thereto. Note that when an electrode is not commonly used for bias and electrostatic chuck, a bias connection terminal and an electrostatic chuck connection terminal may be both disposed on the inner periphery side of the O-ring 12. In addition, when multiple common connection terminals 19 are used for supplying a high electric power, these common connection terminals 19 may be disposed on the inner periphery side of the O-ring 12.

Meanwhile, a substrate temperature detection sensor terminal 21 which detects the temperature of the substrate W, and a chuck temperature detection sensor terminal 18 which detects the temperature of the electrostatic chuck 14 may be disposed at any positions, as long as the temperature of the object can be detected, and the sealing characteristics can be maintained. In this embodiment, for example, the substrate temperature detection sensor terminal 21 is led out from the lower surface of the electrostatic chuck 14, through the opening portion 17, while the chuck temperature detection sensor terminal 18 is led out from the lower surface of the electrostatic chuck 14 by penetrating the support stage 10 itself. Note that a thermocouple, a radiation thermometer, or the like is used as a substrate temperature sensor or a chuck temperature sensor. When a thermocouple is used, the thermocouple itself serves as the connection terminal. When a radiation thermometer is used, an optical fiber which transmits infrared rays emitted from the object serves as the connection terminal.

In addition, a flow path 15 for allowing a coolant 16 for cooling to flow therethrough is formed in the support stage 10, and the temperature and the flow rate of the coolant 16 flowing through the flow path 15 in the support stage 10 are controlled so that the support stage 10 itself can be cooled to a desired temperature. By cooling the support stage 10 as described above, the temperature of the O-ring 12 itself can further be lowered, which leads to an extended lifetime of the O-ring 12, and also an improved maintainability. In addition, an inexpensive O-ring having a low heat resistance can also be used.

In addition, in this embodiment, a controlling device (not illustrated) controls the heater power of the electrostatic chuck 14 in the substrate support stage having the above-described structure, in accordance with a control timing of the bias power of the electrostatic chuck 14. Thus, the temperature of the substrate W is stabilized at high-temperature.

Specifically, in the processing, when a plasma P is generated in the vacuum chamber, and a bias is applied to the substrate W electrostatically attracted to the electrostatic chuck 14, a control as shown in the time chart of Part (b) of Fig. 1 is conducted. In this control, the heater power (the bold dashed line in the figure) is reduced at the same time as time t1 at which the bias power (the alternate long and short dashed line in the figure) is increased, and the heater power is increased at the same time as time t2 at which the bias power is reduced. With such a control, the heat balance of the substrate W is kept constant, so that the temperature of the substrate W is kept constant during the processing. At this time, the heater power may be changed in accordance with the change in bias power to thereby keep constant the temperature of the substrate W detected by the substrate temperature sensor.

Accordingly, by use of the substrate support stage having the above-described structure, and by conducting the above-described control, the temperature of the substrate W can be elevated to high-temperature, and the temperature can be stabilized. As a result, for example, in a case of a plasma CVD apparatus, a thin film having a high film quality can be formed.

### (Embodiment 2)

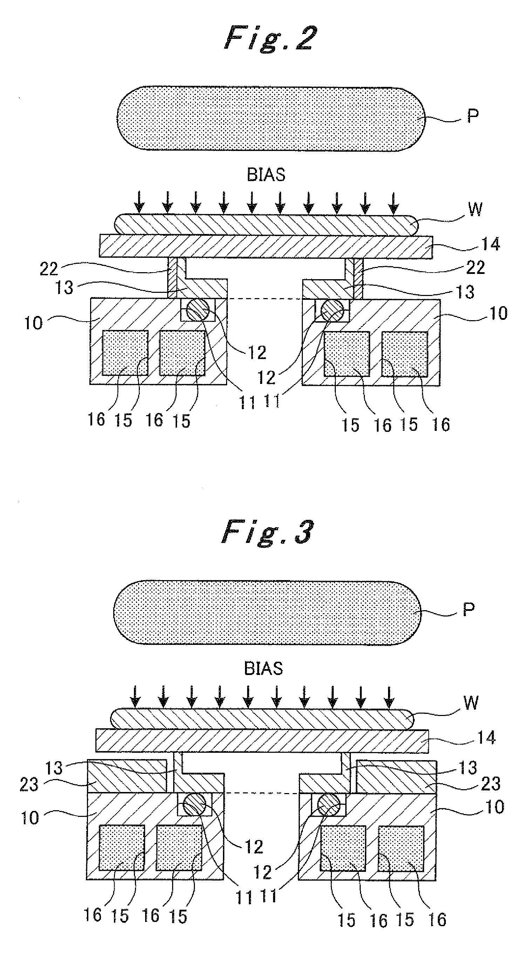

Fig. 2 is a longitudinal cross-sectional view illustrating another example of an embodiment of a substrate support stage of a plasma processing apparatus according to the present invention. Note that the substrate support stage of this embodiment is to be disposed in a vacuum chamber of a plasma processing apparatus, but herein the structures other than that of the substrate support stage, such as the structures of the vacuum chamber, the plasma generation mechanism, and the like are also not shown. In addition, components equivalent to those in the structure of the substrate support stage shown in Embodiment 1 are denoted by the same reference numerals. Moreover, the chuck temperature detection sensor terminal 18, the common connection terminal 19, the heater connection terminal 20, and the substrate temperature detection sensor terminal 21 are not shown in the drawings, and overlapping description thereof is omitted.

As shown in Fig. 2, in this embodiment, an outer peripheral surface and a brazed portion of the flange 13 which is made of Kovar alloy and provided under the electrostatic chuck 14, i.e., a surface on the vacuum side are coated with a coating material 22 made of a material having a high plasma resistance. Examples of the material having a high plasma resistance include yttrium oxide (Y₂O₃), alumina (Al₂O₃), and the like. In a case of Y₂O₃, Y₂O₃ is metal sprayed onto the outer peripheral surface of the flange 13 to carry out the coating.

Kovar alloy is an iron (Fe)-based alloy, and has a low corrosion resistance against plasma of a fluorine-based gas (for example, carbon tetrafluoride (CF₄) or the like), which is a cleaning gas used in the plasma CVD apparatus. However, by coating the surface of the flange 13 made of Kovar alloy with the material having a high plasma resistance, the corrosion of Kovar is inhibited, so that contamination with Fe can be prevented.

Accordingly, by use of the substrate support stage having the above-described structure, and by conducting a control as shown in Part (b) of Fig. 1 of Embodiment 1, the temperature of the substrate W can be elevated to high-temperature, and the temperature can be stabilized.

### (Embodiment 3)

Fig. 3 is a longitudinal cross-sectional view illustrating yet another example of an embodiment of a substrate support stage of a plasma processing apparatus according to the present invention. Note that the substrate support stage of this embodiment is to be disposed in a vacuum chamber of a plasma processing apparatus, but herein the structures other than that of the substrate support stage, such as the structures of the vacuum chamber, the plasma generation mechanism, and the like are also not shown. In addition, components equivalent to those in the structure of the substrate support stage shown in Embodiment 1 are denoted by the same reference numerals. Moreover, the chuck temperature detection sensor terminal 18, the common connection terminal 19, the heater connection terminal 20, and the substrate temperature detection sensor terminal 21 are not shown in the drawings, and overlapping description thereof is omitted.

As shown in Fig. 3, in this embodiment, a ring-shaped member 23 having a shape of a ring and being made of a metal material (for example, aluminum) similar to that of the support stage 10 is provided on the upper surface of the support stage 10 on an outer periphery side of the flange 13. In addition, a gap between a corresponding surface of the ring-shaped member 23 and each of the lower surface of the electrostatic chuck 14 and the outer peripheral surface of the flange 13 is set at 0.5 mm or more, and 2.0 mm or less. This is because of the following reasons. By setting the gap at 2.0 mm or less, the electrical discharge is prevented on the lower surface of the electrostatic chuck 14. Meanwhile, in relation to manufacturing precision, the lower limit of the gap is set at 0.5 mm or more, so that the ring-shaped member 23 is prevented from being brought into contact with the electrostatic chuck 14 and the flange 13, and that heat is prevented from being transferred directly from the electrostatic chuck 14 or the flange 13 to the ring-shaped member 23. Note that the outer diameter of the ring-shaped member 23 can be any size as long as the outer diameter is equal to or larger than that of the electrostatic chuck 14.

Meanwhile, the indirect heat transfer, i.e., heat radiation, from the electrostatic chuck 14 or the flange 13 to the ring-shaped member 23 side is unavoidable. In this respect, to cool the ring-shaped member 23 itself, a carbon sheet may be interposed between the ring-shaped member 23 and the support stage 10 to thereby improve the heat transfer efficiency between the ring-shaped member 23 and the support stage 10, or the ring-shaped member 23 itself may be formed integrally with the support stage 10. Moreover, the surface of the ring-shaped member 23 may be subjected to alumite-processing to thereby increase the emissivity (for example, an emissivity of 0.7 or higher), and improve the radiant heat transfer efficiency. The surface of the ring-shaped member 23 may be subjected to alumite-processing so that particularly the heat radiation from the lower surface of the electrostatic chuck 14 whose temperature reaches high temperature may be actively absorbed

Accordingly, by use of the substrate support stage having the above-described structure, and by conducting a control as shown in Part (b) of Fig. 1 of Embodiment 1, the temperature of the substrate W can be elevated to high-temperature, and the temperature can be stabilized.

### INDUSTRIAL APPLICABILITY

The present invention is applicable to a plasma processing apparatus for manufacturing a insulating film for a semiconductor device which is used as an interlayer insulating film, a barrier metal layer, an etch stopper layer, a passivation film, a hard mask, a CAP film, or the like, and is especially suitable in cases where a high-temperature treatment is necessary.

## Claims

1. A substrate support stage of a plasma processing apparatus, comprising:
an electrostatic attraction plate incorporating a first electrode for electrostatically attracting a substrate, a second electrode for applying a bias to the substrate, and a heater for heating the substrate;
a tubular flange which is welded to a lower surface of the electrostatic attraction plate and which is made of an alloy having thermal characteristics similar to thermal characteristics of the electrostatic attraction plate; and
a support stage which has a sealing member on a surface facing a lower surface of the flange, and to which the flange is attached with the sealing member being interposed therebetween, wherein
when a bias power supplied to the second electrode is changed, a heater power supplied to the heater is changed to thereby keep the temperature of the substrate constant.

2. The substrate support stage of a plasma processing apparatus according to claim 1, wherein
the flange has such a height to form a temperature gradient in which the temperature of the lower surface of the flange is 200°C or below.

3. The substrate support stage of a plasma processing apparatus according to claim 1 or 2, wherein
an outer peripheral surface of the flange is coated with a coating material having a high plasma resistance against a plasma of a fluorine-based gas.

4. The substrate support stage of a plasma processing apparatus according to any one of claims 1 to 3, wherein
a ring-shaped member is provided on an upper surface of the support stage on an outer periphery side of the flange in such a manner that a gap between the ring-shaped member and each of an outer peripheral surface of the flange and the lower surface of the electrostatic attraction plate is 0.5 mm or more, and 2.0 mm or less.

5. The substrate support stage of a plasma processing apparatus according to any one of claims 1 to 4, wherein
a first connection terminal to be connected to the first electrode, a second connection terminal to be connected to the second electrode, and a third connection terminal to be connected to the heater are disposed on an inner periphery side of the flange, and are connected to the first electrode, the second electrode, and the heater, respectively, whereby the first connection terminal, the second connection terminal, and the third connection terminal are disposed on an atmosphere side, which is the inner periphery side of the flange.

6. The substrate support stage of a plasma processing apparatus according to any one of claims 1 to 5, wherein
a flow path is provided in the support stage, and
a coolant for cooling the support stage is allowed to flow through the flow path.
